# EUROPÄISCHE PATENTSCHRIFT

(11) **EP 1 241 781 B1**
(45) Veröffentlichungstag und Bekanntmachung des Hinweises auf die Patenterteilung: **10.08.2005**
(21) Anmeldenummer: 01106256.9
(22) Anmeldetag: 14.03.2001
(51) Int. Cl.: H03F 1/32

(54) **Verfahren und Vorrichtung zur digitalen Vorverzerrungs-/Frequenzgangkompensations- und Feedforward-Linearisierung eines Sendesignals**
Method and device for digitally predistorting and feedforward-linearisation of a transmission signal
Procédé et appareil pour le prédistorsion numérique et la linéarisation de type correction en aval d'un signal d'emission

(43) Veröffentlichungstag der Anmeldung: 18.09.2002
(73) Patentinhaber: SIEMENS AKTIENGESELLSCHAFT, 80333 München (DE)
(72) Erfinder: Felgentreff, Tilman, 83607 Holzkirchen (DE)

(56) Entgegenhaltungen:
- EP-A- 0 930 699
- EP-A- 0 936 731
- GB-A- 2 352 570
- US-A- 5 877 653

## Beschreibung

Die vorliegende Erfindung bezieht sich auf ein Verfahren zur Linearisierung eines digital erzeugten Sendesignals mit kombinierter digitaler Vorverzerrungs/Frequenzgangkompensationslinearisierung und Feedforward-Linearisierung (Vorwärtskorrektur-Linearisierung).

Weiterhin bezieht sich die vorliegende Erfindung auf Vorrichtungen mittels derer das erfindungsgemäße Verfahren durchführbar ist.

Bekannte Modulationsverfahren mit einem Amplitudenmodulationsanteil erzeugen an den nichtlinearen Komponenten eines Sendesignals störende Signalanteile, wie z.B. eine spektrale Verbreiterung der Frequenzen des Sendesignals und das Anwachsen von Fehlersignalen.

Aus "High Linearity RF Amplifier Design", Artech House, ISBN 1-58053-143-1 von P. B. Kerington sind z.B. Verfahren zur Linearisierung von digitalen Signalen bekannt, insbesondere von digitalen Signalen, wie sie in den Sendern in den Stationen eines digitalen Mobilfunknetzes auftreten. Dabei handelt es sich insbesondere z.B. um sogenannte Feedback- (Rückkopplungs-), Feedforward- (Vorwärtskorrektur-) und Predistortion-(digitale Vorverzerrungs-)Verfahren. Weiterhin sind aus diesem Stand der Technik sogenannte lineare Verstärker bekannt, die mit Backoff (Unteraussteuerung) im sogenannten Class A-Betrieb betrieben werden. Diese bekannten lineare Verstärker haben im allgemeinen jedoch einen zu geringen Wirkungsgrad.

Bei aus diesem Stand der Technik bekannten Verfahren hat insbesondere das Verfahren des Feedforward (FF = Vorwärtskorrektur) eine breite Anwendung gefunden Dieses Verfahren wird z.B. bei sogenannten Multicarrier Poweramplifiern (Mehrkanalträger-Leistungsverstärkern) für den UMTS Standard (vgl. ETSI Norm ETSI/3088 unter www.etsi.org)angewandt.

Das Feedforward-Verfahren verlangt einen großen schaltungstechnischen Aufwand, hat aber den Vorteil, auch zeitabhängige Verzerrungen zu linearisieren. Um z.B. Mehrkanalträger-Leistungsverstärker realisieren zu können, die die GSM-Spezifikation erfüllen (vgl. GSM Norm 05.05), ist mehr als eine einzelne Feedforward-Schleife (Vorwärtskorrekturschleife) zur Linearisierung eines Sendesignals notwendig. Mit jeder zusätzlichen Feedforward-Schleife sinkt jedoch der Wirkungsgrad des Verstärkers, und die Kosten steigen. Aus diesem Grunde ist das aus "High Linearity RF Amplifier Design" bekannte Verfahren zum Hintereinanderschalten mehrerer Feedforward-Schleifen in der Praxis unerwünscht.

Demgegenüber ist die Linearisierung mittels einer digitalen Vorverzerrung (digital predistortion) sehr preiswert zu realisieren, wenn man sich digitaler anwendungsfallspezifisch integrierter Schaltkreise, sogenannter ASICs, bedient. Ein solches Verfahren ist z.B. auch in "High Linearity RF Amplifier Design" offenbart.

Diese Vorgehensweise alleine ist jedoch noch nicht ausreichend, um z.B. die Linearisierungsanforderungen der GSM-Norm zu erfüllen.

Insbesondere in digitalen Mobilfunknetzen ergeben sich durch die modernen Modulationsverfahren mit ihren hohen Spitzen- zu Mittelwerten bei der Modulation immer weitergehende Anforderungen an hochgradig linearisierte Signale, wobei die Linearisierung möglichst preiswert durchgeführt werden soll. Insbesondere beim Mehrkanalträgerbetrieb ergeben sich in der Praxis sehr hohe Anforderungen an die Linearität der Sendeverstärker. Diese Anforderungen können die oben erläuterten bekannten Verfahren nicht befriedigend erfüllen.

Aus der GB 2352570 A ist eine linearisierende Vorrichtung sowie ein linearisierendes Verfahren bekannt, die eine Vorverzerrung mit Feedforward-Schleife ermöglichen, wobei ein Vorverzerrer eine Referenz für die Feedforward-Schleife liefert.

Aufgabe der vorliegenden Erfindung ist es, ein günstiges Verfahren zur Linearisierung eines digitalen Signals eines Senders, insbesondere eines Senders in einer Basisstation oder einer Mobilstation eines digitalen Mobilfunknetzes bereitzustellen.

Dies geschieht erfindungsgemäß durch die Maßnahmen des Anspruchs 1. Weiterhin wird erfindungsgemäß eine Vorrichtung mit den Merkmalen des Anspruchs 9 bereitgestellt, mittels derer das erfindungsgemäße Verfahren durchführbar ist. Die abhängigen Ansprüche betreffen bevorzugte Ausführungsformen der vorliegenden Erfindung.

Die Vorteile und Merkmale der vorliegenden Erfindung ergeben sich auch aus den nachfolgenden Ausführungsbeispielen in Verbindung mit den Zeichnungen.

Es zeigen:
Fig. 1 ein Blockschaltbild einer Baugruppe zur erfindungsgemäßen kombinierten Durchführung einer digitalen Vorverzerrungs-/Frequenzgangkompensationslinearisierung mit einer Feedforward-Linearisierung;
Fig. 2 ein Blockschaltbild einer Baugruppe, welche digitale Aufwärtsmischer zur Erzeugung eines vorverzerrten/frequenzgangkompensierten Signals und eines Referenzsignals verwendet, wie sie der in Fig. 1 gezeigten Baugruppe zugeführt werden;
Fig. 3 ein Blockschaltbild einer Baugruppe, welche IQ-Modulatoren (Inphase-Quadraturephase Modulatoren = Vektormodulatoren) zur Erzeugung eines vorverzerrten/frequenzgangkompensierten Signals und eines Referenzsignals verwendet, wie sie der in Fig. 1 gezeigten Baugruppe zugeführt werden.

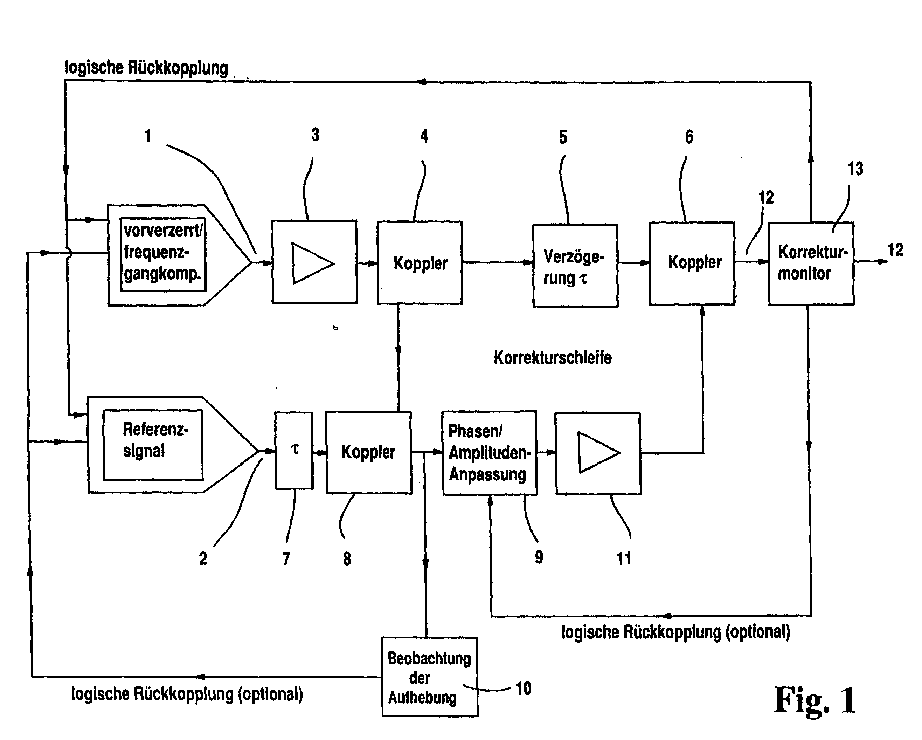

Die in Fig. 1 gezeigte Baugruppe umfasst obenliegend gezeichnet eine erste Signalbearbeitungskette zur Erzeugung eines vorverzerrten/frequenzgangkompensierten Signals sowie untenliegend gezeichnet eine zweite Signalbearbeitungskette zur Erzeugung eines Referenzsignals. Wie im folgenden ausgeführt wird, sind die erste und die zweite Signalbearbeitungskette miteinander gekoppelt, um eine Korrekturschleife zur Linearisierung eines digitalen Signals zu bilden.

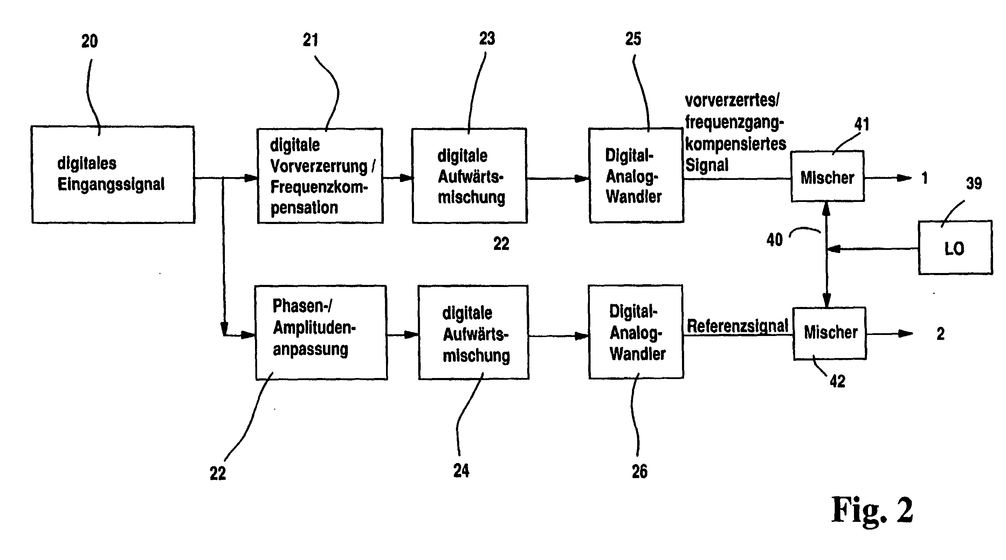

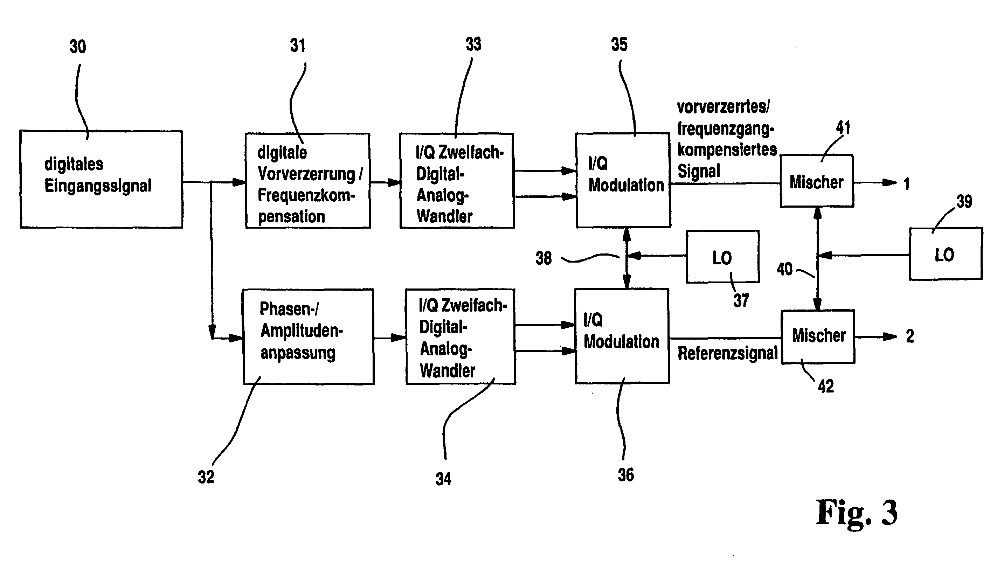

Die Erzeugung eines in Fig. 1 über eine erste Eingabeleitung 1 eingehenden analogen vorverzerrten/frequenzgangkompensierten Signals und die Erzeugung eines über eine zweite Eingabeleitung 2 eingehenden analogen Referenzsignals werden weiter unten eingehender in Verbindung mit Fig. 2 und 3 erläutert.

In der in Fig. 1 oben liegend gezeichneten ersten Signalbearbeitungskette wird ein über eine erste Verbindungsleitung 1 eingehendes analoges vorverzerrtes und/oder frequenzgangkompensiertes Signal auf einen nichtlinearen Hauptverstärker 3 gegeben und dort verstärkt.

Das vom nichtlinearen Hauptverstärker 3 verstärkte analoge vorverzerrte/frequenzgangkompensierte Signal wird auf einen ersten Koppler 4 gegeben. Einerseits gibt der erste Koppler 4 das verstärkte analoge vorverzerrte/frequenzgangkompensierte Signal auf eine erste Verzögerungseinheit 5 weiter. Andererseits steht der erste Koppler 4 mit einem zweiten Koppler 8 in der zweiten Signalbearbeitungskette in Verbindung.

Die erste Verzögerungseinheit 5 steht mit einem dritten Koppler 6 in Verbindung. Dieser steht auch mit dem Ausgang eines sich in der unteren Signalbearbeitungskette befindlichen Verstärkers 11 in Verbindung.

Ein über die zweite Eingabeleitung 2 eingehendes analoges Referenzsignal wird in der unteren Signalbearbeitungskette zunächst auf eine zweite optionale Verzögerungseinheit 7 gegeben. Das von der zweiten Verzögerungseinheit 7 verzögert ausgegebene Referenzsignal wird auf den zweiten Koppler 8 gegeben, wo es mit dem aus dem ersten Koppler 4 zugeführten verstärkten vorverzerrten/frequenzgangkompensierten Signal kombiniert wird.

Der zweite Koppler 8 gibt sodann die Differenz aus dem vom ersten Koppler 4 eingespeisten verstärkten vorverzerrten/frequenzgangkompensierten Signal und dem verzögerten Referenzsignal als Aufhebungssignal (Fehlersignal) einerseits auf eine optionale Vorrichtung 10 zur Beobachtung der Aufhebung der beiden Signale, andererseits auf eine Einheit 9 zur Anpassung der Phase und der Amplitude des Fehlersignals. Die Einheit 9 gibt ein phasen- und amplitudenangepasstes Fehlersignal auf einen zweiten Verstärker 11. Dieser zweite Verstärker 11 hat die Funktion eines Fehlerverstärkers in der Korrekturschleife.Von der optionalen Vorrichtung 10 zur Beobachtung der Aufhebung der beiden Signale wird optional ein Rückkopplungssignal (sogenanntes "logisches Feedback") zu den weiter unten ausführlicher erläuterten Einheiten 21, 22 bzw. 31, 32 (siehe Fig. 2 und 3) gegeben.

Der zweite Verstärker 11 gibt ein verstärktes phasen- und amplitudenangepasstes Fehlersignal auf den dritten Koppler 6.

Im dritten Koppler 6 werden das aus der zweiten Verzögerungseinheit 5 in der ersten Signalbearbeitungskette stammende verzögerte verstärkte vorverzerrte/frequenzgangkompensierte Signal und das aus dem zweiten Verstärker 11 in der unteren Signalbearbeitungskette stammende verstärkte phasen- und amplitudenangepasste Fehlersignal zusammengeführt, d.h. voneinander substrahiert. Das im Koppler 6 zusammengeführte Signal ist nun wegen der Subtraktion des Fehlersignals hochgradig linearisiert.
Das aus dieser Subtraktion resultierende hochgradig linearisierte Signal wird über eine Ausgabeleitung auf einen Korrekturmonitor 13 gegeben, von wo ein optionales Rückkopplungsignal ("logisches Feedback") zu den weiter unten ausführlicher erläuterten Einheiten 21, 22 bzw. 31, 32 (siehe Fig. 2 und 3) zurückgeführt wird. Vom Korrekturmonitor 13 wird das hochgradig linearisierte Signal weiter über die Ausgabeleitung auf eine Sendeantenne (nicht gezeigt) geführt.

Die Anordnung aus erstem Koppler 4, erster Verzögerungseinheit 5, drittem Koppler 6, zweitem Koppler 8, Einheit 9 zur Anpassung der Phase und der Amplitude des Fehlersignals und Fehlerverstärker 11 bildet eine Vorwärtskorrekturschleife für einen Feedforward-Verstärker.

In Fig. 2 ist das Blockschaltbild einer Baugruppe zur Erzeugung eines vorverzerrten/frequenzgangkompensierten Signals und eines Referenzsignals gemäß einer ersten Ausführungsform zu sehen, für deren Erzeugung digitale Aufwärtsmischer verwendet werden.

In der in Fig. 2 gezeigten Baugruppe werden in eine digitale Sendeeinheit 20, wie sie z.B. in einer Basisstation oder einer Mobilstation in einem digitalen Mobilfunknetz Verwendung findet, eingehende digitale modulierte Daten (auch für mehrere Trägerfrequenzen) in eine in Fig. 2 oben liegend gezeichnete Vorverzerrungs/Frequenzgangkompensationssignalerzeugungskette und in eine in Fig. 2 unten liegend gezeichnete Referenzsignalerzeugungskette eingespeist.

In der Vorverzerrungs/Frequenzgangkompensationssignalerzeugungskette gelangen die von der digitalen Sendeeinheit 20 kommenden digitalen modulierten Daten zunächst in eine Einheit 21 zur Vorverzerrung und/oder Frequenzgangkompensation. Dort werden die parametrisierten digitalen Daten durch numerische Manipulation der Parameter manipuliert, also "numerisch verzerrt". Die so verzerrten Daten werden z.B. durch numerisch gewählte Verzerrungskoeffizienten repräsentiert. Die digitale Vorverzerrung und/oder die Frequenzgangkompensation haben das Ziel, die Nichtlinearität des Hauptverstärkers 3 in dem Sinne zu kompensieren, dass die Leistung des Fehlersignals nach dem Koppler 8 minimiert wird. Bei der Frequenzgangkompensation wird insbesondere die Nichtlinearität des Hauptverstärkers 3 bei der frequenzspezifischen Leistungsabgabe kompensiert.

Von der Einheit 21 zur Vorverzerrung und/oder Frequenzgangkompensation werden vorverzerrte und/oder frequenzgangkompensierte digitale modulierte Daten in eine optionale erste Einheit 23 zur digitalen (Frequenz)-Aufwärtsmischung gegeben. Von dort werden aufwärtsgemischte vorverzerrte/ frequenzgangkompensierte digitale modulierte Daten in einen ersten Digital-Analog-Wandler 25 gegeben. Dieser gibt sodann über die erste Eingabeleitung 1 analoge aufgewärtsgemischte vorverzerrte/frequenzgangkompensierte Signale auf den in Fig. 1 gezeigten nichtlinearen Hauptverstärker 3.

In der in Fig. 2 untenliegend gezeigten Referenzsignalkette werden die von der Sendeeinheit 20 eingespeisten digitalen modulierten Daten (auch für mehrere Trägerfrequenzen) auf eine Einheit 22 zur Anpassung der Phase und der Amplitude gegeben. Von dort werden phasen- und amplitudenangepasste digitale modulierte Daten auf eine optionale zweite Einheit 24 zur digitalen (Frequenz-)Aufwärtsmischung gegeben. Diese schickt (frequenz-)aufwärtsgemischte phasen- und amplitudenangepasste digitale modulierte Daten auf einen zweiten Digital-Analog-Wandler 26. Dieser gibt sodann über die zweite Eingabeleitung 2 ein analoges Referenzsignal auf die in Fig. 1 gezeigte optionale zweite Verzögerungseinheit 7.

In Fig. 2 sind die erste und zweite Einheit 23, 24 zur digitalen Aufwärtsmischung optional und dienen zur Umsetzung der Frequenz des Eingangssignals in eine Zwischenfrequenzlage.

In Fig. 3 ist für eine zweite Ausführungsform das Blockschaltbild einer Baugruppe zu sehen, bei welcher I/Q Modulatoren (Vektormodulatoren) verwendet werden, um ein vorverzerrtes und/oder frequenzgangkompensiertes Signal sowie ein Referenzsignal zu erzeugen, die zur weiteren Bearbeitung in die in Fig. 1 gezeigte Baugruppe zur Durchführung des erfindungsgemäßen Verfahrens eingespeist werden.

In Fig. 3 werden von einer Sendeeinheit 30, wie sie z.B. in einer Basisstation oder einer Mobilstation in einem digitalen Mobilfunknetz Verwendung findet, eingehende digitale modulierte Daten, in eine in Fig. 3 oben liegend gezeichnete Vorverzerrungs-/Frequenzgangkompensationssignalerzeugungskette und in eine in Fig. 3 unten liegend gezeichnete Referenzsignalerzeugungskette eingespeist.

In der Vorverzerrungs/Frequenzgangkompensationssignalerzeugungskette gelangen die von der Sendeeinheit 30 kommenden digitalen modulierten Daten zunächst in eine Einheit 31 zur digitalen Vorverzerrung und/oder Frequenzgangkompensation. Auch hier findet eine "numerische Vorverzerung" und/oder eine Frequenzgangkompensation statt. Von der Einheit 31 werden vorverzerrte und/oder frequenzgangkompensierte digitale modulierte Daten in eine erste Einheit 33 zur I/Q-Zweifach-DA-Wandlung gegeben. Von dort werden analoge gewandelte Daten in einen I/Q-Modulator 35 gegeben.

In der in Fig. 3 gezeigten Referenzsignalerzeugungskette werden die von der Sendeeinheit 30 eingespeisten digitalen modulierten Daten auf eine Einheit 32 zur Anpassung der Phase und der Amplitude gegeben. Von dort werden phasen- und amplitudenangepasste digitale modulierte Daten auf eine zweite Einheit 34 zur I/Q-Zweifach-DA-Wandlung gegeben. Die zweite Einheit 34 zur I/Q-Zweifach-DA-Wandlung schickt analoge gewandelte Daten auf einen zweiten I/Q-Modulator 36.

Der erste I/Q-Modulator 35 und der zweite I/Q-Modulator 36 sind über eine optionale erste Verbindungsleitung 38 miteinander verbunden. In die erste Verbindungsleitung 38 werden Signale von einer optionalen LO-Einheit 37 (local oscillator = lokaler Schwingkreis) eingespeist. Dadurch kann eine Frequenzumsetzung der von den I/Q Dual-Digital-Analog-Wandlern 33, 34 kommenden Signale stattfinden. Die erste Verbindungsleitung dient dazu, das von der LO-Einheit 37 eingespeiste Signal phasengleich zu verteilen.

Aus der Vorverzerrungs/Frequenzgangkompensationssignalerzeugungskette wird sodann über die erste Eingabeleitung 1 ein analoges vorverzerrtes und/oder frequenzgangkompensiertes Signal auf den in Fig. 1 gezeigten nichtlinearen Hauptverstärker 3 gegeben.

Aus der Referenzsignalerzeugungskette wird sodann über eine zweite Eingabeleitung 2 ein analoges Referenzsignal auf die in Fig. 1 gezeigte zweite Verzögerungseinheit 7 gegeben.

Erfindungsgemäß wird ein Verfahren zur Linearisierung eines Eingangssignals mittels Feedforward mit einem Verfahren zur digitalen Vorverzerrung und/oder Frequenzgangkompensation kombiniert. Dadurch ergibt sich eine sehr hohe Linearisierungswirkung bei einem relativ geringen schaltungstechnischen Aufwand.

Erfindungsgemäß werden zwei verschiedende Signale, nämlich ein digital vorverzerrtes und/oder frequenzgangkompnesiertes Signal und ein unverzerrtes Referenzsignal in der Korrekturschleife eines Feedforward-Verstärkers kombiniert. Das Referenzsignal dient zur Kompensation des vorverzerrten Signals in der Korrekturschleife.

Die notwendige adaptive Einstellung der Phase und der Amplitude des vorverzerrten/frequenzgangkompensierten Signals und des Referenzsignals für eine optimale Unterdrückung des Signalanteils im Fehlerverstärker 11 erfolgt durch Rückkopplung ("logisches Feedback").

Wie in Fig. 1 zu sehen ist, erfolgt eine optionale logische Rückkopplung von dem Korrekturmonitor 13 in der Ausgabeleitung 12 auf die Vorverzerrungs/Frequenzgangkompensationssignalerzeugungskette (genauer: auf die sich dort befindlichen Einheiten 21 bzw. 31) und die Referenzsignalerzeugungskette (genauer: auf die sich dort befindlichen Einheiten 22 bzw. 32), und/oder eine optionale logische Rückkopplung von dem Korrekturmonitor 13 auf die Einheit 9 zur Anpassung der Phase und Amplitude des Fehlersignals in der Korrekturschleife, und/oder eine optionale logische Rückkopplung von der Vorrichtung 10 zur Beobachtung des Aufhebungssignals auf die Vorverzerrungs/Frequenzgangkompensationssignalerzeugungskette (genauer: auf die sich dort befindlichen Einheiten 21 bzw. 31) und die Referenzsignalerzeugungskette (genauer: auf die sich dort befindlichen Einheiten 22 bzw. 32).

Durch solche logische Rückkopplungen werden die Phase und die Amplitude des Referenzsignals und die Vorverzerrungskoeffizienten bzw. die Frequenzgangkompensation des auf den Hauptverstärker 3 über die Eingabeleitung 1 gegebenen Signals so eingestellt, dass z.B. eine minimale Leistung nach dem zweiten Koppler 8 durch die Einheit 10 zur Überwachung der Aufhebung in der Korrekturschleife gemesssen wird.

Wichtig ist, dass zumindest eine der drei in Fig. 1 gezeigten logischen Rückkopplungsschleifen ausgebildet ist, optional können zwei oder alle drei logischen Rückkopplungsschleifen miteinander kombiniert sein, um die Stabilisierung der Rückkopplung zu erhöhen.

Der zweite Koppler 8 speist den sogenannten Fehlerverstärker 11 in der Korrekturschleife. Die nochmalige Anpassung der Phase und Amplitude des Fehlersignals in der Einheit 9 dient zur genauen Einstellung des Korrektursignals im Verhältnis zum Signal des Hauptverstärkers, und insbesondere auch zur Kompensation eines Temperaturdrifts und zur Kompensation des Frequenzgangs des Fehlerverstärkers 11.

Die Korrekturschleife hat dieselbe Wirkung wie in einem herkömmlichen Feedforward-Verstärker.

Die separate Erzeugung des vorverzerrten und/oder frequenzgangkompensierten Signals hat den weiteren Vorteil, dass für die adaptive Einstellung der Phase und der Amplitude des Fehlersignals eventuell benötigte Pilottöne (das sind bewusst in die digitalen Eingangssignale eingeführte Fehlersignale mit kleiner Amplitude) ohne zusätzlichen schaltungstechnischen Aufwand ebenfalls digital erzeugt werden können. Die Phasen- und Amplitudeneinstellung (oder I/Q-Einstellung) in der Korrekturschleife wird so gewählt, dass eine maximale Unterdrückung der um 180° phasenverschobenen und in der Korrekturschleife verstärkten Fehlersignale (= Korrektursignale) erreicht wird. Dies geschieht durch die Einheit 9. Die Erzeugung des Referenzsignals und des vorverzerrten/frequenzgangkompensierten Signals kann auf einer Endfrequenzlage oder auf einer Zwischenfrequenz erfolgen, die dann noch auf die Endfrequenz umgesetzt werden muss.

Zur Erzeugung des Referenzsignals und des vorverzerrten Signals gibt es, wie in Verbindung mit Fig. 2 und 3 erläutert, verschiedene Möglichkeiten. Die in Fig. 3 gezeigten analogen I/Q-Modulatoren wirken dabei auf eine Endfrequenz oder eine Zwischenfrequenz ein. Eine Zwischenfrequenz wird durch einen optionalen ersten lokalen Oszillator 37 und/oder einen optionalen zweiten lokalen Oszillator 39 erzeugt. Die vom optionalen zweiten lokalen Oszillator 39 erzeugte Zwischenfrequenz wird dem vorverzerrten/frequenzgangkompensierten Signal bzw. dem Referenzsignal über eine zweite Verbindungsleitung 40 und je einen Mischer 41 bzw. 42 zugemischt. Dadurch erfolgt eine Frequenz-Umsetzung des I/Q modulierten I/Q Zweifach-Digital-Analog-gewandelten digital vorverzerrten Eingangssignals mit dem I/Q modulierten I/Q Zweifach-Digital-Analog-gewandelten digital vorverzerrten Signals.

Je nach der ausgewählten Erzeugungsart muss ein eventuell noch auftretender Verzögerungsunterschied, der die Linearisierungsbandbreite beschränkt, durch die Einfügung einer zusätzlichen Verzögerungseinheit nach der Referenzsignalerzeugung ausgeglichen werden. Hierzu dient die in Fig. 1 gezeigte optionale zweite Verzögerungseinheit 7.

Der Vorteil der erfindungsgemäßen Lösung besteht darin, dass sie zwei effiziente Linearisierungsverfahren kombiniert, und damit eine sehr hohe Linearisierungswirkung erreicht.

Gleichzeitig ist sie in idealer Weise mit neuartigen hoch integrierten Wandlerkonzepten realisierbar, die z.B. direkt in der Endfrequenzlage arbeiten.
Damit ist es möglich, mit einer Lösung zu arbeiten, die im Vergleich zur Einfügung einer zweiten Feedforward-Schleife wesentlich kostengünstiger ist und im Vergleich zu einer ausschließlich adaptiven Vorverzerrung auf der Endfrequenzlage eine hohe Linearisierung erreichen kann.

## Patentansprüche

1. Verfahren zur Linearisierung eines Ausgabesignals (12), insbesondere eines Sendesignals in einem Sender, der- sich in einer Station in einem digitalen Mobilfunknetz befindet,
mit folgenden verfahrensschritten:
digitales Vorverzerren und Frequenzgangkompensieren (21; 31) eines digitalen Eingangssignals;
Digital-Analog-Wandeln (25; 33) des digital vorverzerrten und frequenzgangkompensierten Signals zur Erzeugung eines analogen vorverzerrten und frequenzgangkompensierten Signals (1) ;
Verstärken (3) des analogen vorverzerrten und frequenzgangkompensierten Signals (1);
Erzeugen eines analogen phasen- und amplitudenangepassten Referenzsignals (2) aus dem digitalen Eingangssignal;
Erzeugen eines Fehlersignals durch Subtraktion des verstärkten analogen vorverzerrten und frequenzgangkompensierten Signals und des analogen phasen- und amplitudenangepassten Referenzsignals voneinander (4, 8), und Überlagern (6) des Fehlersignals mit dem verstärkten analogen vorverzerrten und frequenzgangkompensierten Signal zu dem Ausgabesignal (12),
**gekennzeichnet dadurch,**
**dass** eine numerische Variation (21) des digital vorverzerrten und frequenzgangkompensierten Signals sowie eine Phasen- und Amplitudenanpassung des Referenzsignals durch logische Rückkopplung von das Ausgabesignal (12) bewertenden Messgrößen auf das digital vorverzerrte und frequenzgangkompensierte Signal und das phasen- und amplitudenangepasste Referenzsignal durchgeführt wird.

2. Verfahren nach Anspruch 1
**gekennzeichnet durch**,
Anpassen der Phase und der Amplitude des leistungsminimierten Fehlersignals und Kombinieren des phasen- und amplitudenangepassten Fehlersignals mit dem verzögerten analogen vorverzerrten und frequenzgangkompensierten Signal zu einem linearisierten Ausgabesignal.

3. Verfahren nach Anspruch 1 oder 2,
**dadurch gekennzeichnet,**
**dass** das analoge vorverzerrte und frequenzgangkompensierte Signal vor dem Erzeugen des Fehlersignals verstärkt wird.

4. Verfahren nach einem der Ansprüche 1 bis 3,
**dadurch gekennzeichnet,**
**dass** das phasen- und amplitudenangepasste Fehlersignal vor dem Kombinieren mit dem verzögerten analogen vorverzerrten Signal verstärkt wird.

5. Verfahren nach einem der Ansprüche 1 bis 4,
**dadurch gekennzeichnet,**
**dass** das analoge vorverzerrte und frequenzgangkompensierte Signal folgendermaßen aus dem digital vorverzerrten und frequenzgangkompensierten Signal gewonnen wird:
optionales digitales Aufwärtsmischen des digital vorverzerrten und frequenzgangkompensierten Signals;
Digital-Analog-Wandeln des aufwärtsgemischten digital vorverzerrten und frequenzgangkompensierten Signals.

6. Verfahren nach einem der Ansprüche 1 bis 4,
**dadurch gekennzeichnet,**
**dass** das analoge vorverzerrte und frequenzgangkompensierte Signal folgendermaßen aus dem digital vorverzerrten und frequenzgangkompensierten Signal gewonnen wird:
I/Q Zweifach-Digital-Analog-Wandeln des digital vorverzerrten und frequenzgangkompensierten Signals;
I/Q Modulieren des I/Q Zweifach-Digital-Analog-gewandelten Signals zur Erzeugung des analogen vorverzerrten und frequenzgangkompensierten Signals.

7. Verfahren nach einem Ansprüche 1 bis 5,
**dadurch gekennzeichnet,**
**dass** das Referenzsignal folgendermaßen aus dem digitalen Eingangssignal gewonnen wird:
Anpassen der Phase und der Amplitude des digitalen Eingangssignals;
digitales Aufwärtsmischen des phasen- und amplitudenangepassten Signals;
Digital-Analog-Wandeln des aufwärtsgemischten Signals.

8. Verfahren nach Anspruch 6,
**dadurch gekennzeichnet,**
**dass** das Referenzsignal folgendermaßen aus dem digitalen Eingangssignal Signal gewonnen wird:
Anpassen der Phase und der Amplitude des digitalen Eingangssignals;
I/Q Zweifach-Digital-Analog-Wandeln des phasen- und amplitudenangepassten Signals;
I/Q Modulieren des I/Q Zweifach-Digital-Analog-gewandelten Signals zur Erzeugung des analogen phasen- und amplitudenangepassten Referenzsignals, wobei das I/Q modulierte Referenzsignal mit dem I/Q modulierten vorverzerrten und frequenzgangkompensierten Signal frequenzabgeglichen wird.

9. Vorrichtung zur Linearisierung eines Ausgabesignals (12), insbesondere eines Sendesignals in einem Sender, der in einer Station in einem digitalen Mobilfunknetz verwendbar ist,
wobei die Vorrichtung umfasst:
eine erste Signalbearbeitungsstrecke mit einer digitalen Vorverzerrungs- und Frequenzgangkompensationseinheit (21; 31), in die ein in einer Sendeeinheit (20; 30) erzeugtes digitales Eingangssignal eingespeist und digital vorverzerrt und frequenzgangkompensiert wird, auf der ein aus dem digital vorverzerrten und frequenzgangkompensierten Signal abgeleitetes analoges vorverzerrtes und frequenzgangkompensiertes Signal in einen nichtlinearen Hauptverstärker (3) geführt wird,
eine zweite Signalbearbeitungsstrecke, auf der ein aus dem digitalen Eingangssignal abgeleitetes analoges Referenzsignal geführt wird;
Mittel (4, 8), um das verstärkte analoge vorverzerrte und frequenzgangkompensierte Signal und das analoge Referenzsignal zu einem Fehlersignal zu kombinieren und in die zweite Signalbearbeitungsstrecke einzuführen;
Mittel (21; 31) in der ersten Signalbearbeitungsstrecke und Mittel (22; 32) in der zweiten Signalbearbeitungsstrecke, um die Vorverzerrung und Frequenzgangkompensation des vorverzerrten und frequenzgangkompensierten Signals und die Phase und die Amplitude des Referenzsignals zu variieren;
Mittel (6), welche das Fehlersignal mit dem verstärkten analogen vorverzerrten und frequenzgangkompensierten Signal zu dem Ausgabesignal (12) kombinieren;
**dadurch gekennzeichnet,**
**dass** Mittel (13) zur logischen Rückkopplung von das Ausgabesignal (12) bewertenden Messgrößen auf die Mittel (21; 31) in der ersten Signalbearbeitungsstrecke zur Vorverzerrung und Frequenzgangkompensation des digitalen Eingangssignals und auf die Mittel (22; 32) in der zweiten Signalbearbeitungsstrecke zur Variation der Phase und Amplitude des Referenzsignals vorgesehen sind.

10. Vorrichtung nach Anspruch 9,
**dadurch gekennzeichnet,**
**dass** ein zweiter Verstärker (11) in der zweiten Signalbearbeitungsstrecke vorgesehen ist, um das Fehlersignal zu verstärken.

11. Vorrichtung nach Anspruch 9 oder 10,
**dadurch gekennzeichnet,**
**dass** in der zweiten Signalbearbeitungsstrecke eine Einheit (9) zur Anpassung der Phase und Amplitude des Fehlersignals vorgesehen ist.

12. Vorrichtung nach einem der Ansprüche 9 bis 11,
**dadurch gekennzeichnet,**
**dass** die Vorrichtung
eine erste Verzögerungseinheit (5) zur Verzögerung des analogen vorverzerrten und frequenzgangkompensierten Signals in der ersten Signalbearbeitungsstrecke umfasst.

13. Vorrichtung nach einem der Ansprüche 9 bis 12,
**dadurch gekennzeichnet,**
**dass** eine Vorrichtung (10) zur Beobachtung des Fehlersignals in der zweiten Signalbearbeitungsstrecke vorgesehen ist.

14. Vorrichtung nach einem der Ansprüche 9 bis 13,
**dadurch gekennzeichnet,**
**dass** in der zweiten Signalbearbeitungsstrecke vor den Mitteln (4, 8) zur Erzeugung und Bereitstellung des Fehlersignals, eine zweite Verzögerungseinheit (7) zum Verzögern des Referenzsignals angebracht ist.

15. Vorrichtung nach einem der Ansprüche 9 bis 14,
**dadurch gekennzeichnet,**
**dass** sie zusätzlich enthält:
eine Sendeeinheit (20, 30) zur Erzeugung des digitalen Eingangssignals;
eine erste Signalformungsstrecke zum Ableiten eines analogen vorverzerrten und frequenzgangkompensierten Signals aus dem digitalen vorverzerrten und frequenzgangkompensierten Signal, wobei der Ausgang der ersten Signalformungsstrecke in eine erste Eingabeleitung (1) mündet, die zum nichtlinearen Hauptverstärker (3) in der ersten Signalbearbeitungsstrecke führt;
eine zweite Signalformungsstrecke zum Ableiten eines analogen Referenzsignals aus dem von der Sendeeinheit erzeugten digitalen Eingangssignal; wobei der Ausgang der zweiten Signalformungsstrecke in eine zweite Eingabeleitung (2) mündet, die zu den Mitteln (8) zur Erzeugung und Bereitstellung des Fehlersignals führt.

16. Vorrichtung nach Anspruch 15,
**dadurch gekennzeichnet,**
**dass** die erste Signalformungsstrecke umfasst:
eine erste Einheit (23) zur digitalen Aufwärtsmischung des von der digitalen Voreverzerrungs- und Frequenzgangkompensationseinheit ausgegebenen Signals;
einen ersten Digital-Analog-Wandler (27), der das von der ersten Einheit (23) ausgegebene Signal in das analoge vorverzerrte und frequenzgangkompensierte Signal wandelt;
und **dass** die zweite Signalformungsstrecke umfasst:
eine zweite Einheit (24) zur digitalen Aufwärtsmischung des von dem Mittel (22) zur Variation der Phase und Amplitude des Referenzsignals ausgegebenen Signals;
einen zweiten Digital-Analog-Wandler (26), der das von der zweiten Einheit (24) ausgegebene Signal in das analoge Referenzsignal wandelt.

17. Vorrichtung nach Anspruch 15,
**dadurch gekennzeichnet,**
**dass** die erste Signalformungsstrecke umfasst:
- eine erste Einheit (33) zur I/Q Zweifach-Digital-Analog-Wandlung des von der digitalen Vorverzerrungs- und Frequenzgangkompensationseinheit (31) ausgegebenen Signals;
einen ersten I/Q-Modulator (35), der das von der ersten Einheit (33) ausgegebenen Signal in das analoge vorverzerrte und frequenzgangkompensierte Signal wandelt;
und **dass** die zweite Signalformungsstrecke umfasst:
eine zweite Einheit (34) zur I/Q Zweifach-Digital-Analog-Wandlung des von dem Mittel (32) zur Variation der Phase und Amplitude des Referenzsignals ausgegebenen Signals;
einen zweiten I/Q-Modulator (35), des das von der zweiten Einheit (33) ausgegebene Signal in das analoge Referenzsignal wandelt;
wobei der erste I/Q-Modulator (35) und der zweite I/Q-Modulator (36) über eine Verbindungsleitung (38) verbunden sind, in die die Signale einer lokalen Schwingkreis-Einheit (37) eingespeist werden.

## Claims

1. Method for linearizing an output signal (12), in particular a transmit signal, in a transmitter which is located in a station in a digital mobile radio network,
having the following method steps:
digital predistortion and frequency response compensation (21; 31) of a digital input signal;
digital/analogue conversion (25; 33) of the digitally predistorted and frequency response compensated signal in order to generate an analogue predistorted and frequency response compensated signal (1);
amplification (3) of the analogue predistorted and frequency response compensated signal (1);
generation of an analogue phase-adapted and amplitude-adapted reference signal (2) from the digital input signal;
generation of a fault signal by subtracting the amplified analogue predistorted and frequency response compensated signal and the analogue phase-adapted and amplitude-adapted reference signal from one another (4, 8), and superimposing (6) the amplified analogue predistorted and frequency response compensated signal on the fault signal in order to form the output signal (12),
**characterized**
**in that** a numeric variation (21) of the digitally predistorted and frequency response compensated signal and phase adaptation and amplitude adaptation of the reference signal is carried out by logically feeding back measurement variables, which evaluate the output signal (12), to the digitally predistorted and frequency response compensated signal and to the phase-adapted and amplitude-adapted reference signal.

2. Method according to Claim 1, **characterized by** adaptation of the phase and the amplitude of the power minimized fault signal and combination of the phase-adapted and amplitude-adapted fault signal with the delayed analogue predistorted and frequency response compensated signal to form a linearized output signal.

3. Method according to Claim 1 or 2, **characterized in that** the analogue predistorted and frequency response compensated signal is amplified before the fault signal is generated.

4. Method according to one of Claims 1 to 3, **characterized in that** the phase-adapted and amplitude-adapted fault signal is amplified before combination with the delayed analogue predistorted signal.

5. Method according to one of Claims 1 to 4, **characterized in that** the analogue predistorted and frequency response compensated signal is acquired from the digitally predistorted and frequency response compensated signal as follows:
optional digital upmixing of the digitally predistorted and frequency response compensated signal;
digital/analogue conversion of the upmixed digitally predistorted and frequency response compensated signal.

6. Method according to one of Claims 1 to 4, **characterized in that** the analogue predistorted and frequency response compensated signal is acquired from the digitally predistorted and frequency response compensated signal as follows:
I/Q dual digital/analogue conversion of the digitally predistorted and frequency response compensated signal;
I/Q modulation of the I/Q dual digital/analogue converted signal for generating the analogue predistorted and frequency response compensated signal.

7. Method according to one of Claims 1 to 5, **characterized in that** the reference signal is acquired as follows from the digital input signal:
adaptation of the phase and the amplitude of the digital input signal;
digital upmixing of the phase-adapted and amplitude-adapted signal;
digital/analogue conversion of the upmixed signal.

8. Method according to Claim 6, **characterized in that** the reference signal is acquired from the digital input signal as follows:
adaptation of the phase and the amplitude of the digital input signal;
I/Q dual digital/analogue conversion of the phase-adapted and amplitude-adapted signal;
I/Q modulation of the I/Q dual digital/analogue converted signal for generating the analogue phase-adapted and amplitude-adapted reference signal, the I/Q modulated reference signal being frequency compensated with the I/Q modulated predistorted and frequency compensated signal.

9. Device for linearizing an output signal (12), in particular a transmit signal in a transmitter, which can be used in a station in a digital mobile radio network,
the device comprising:
a first signal processing path with a digital predistortion and frequency response compensation unit (21; 31) into which a digital input signal which is generated in a transmitter unit (20; 30) is fed and digitally predistorted and frequency response compensated, and on which signal processing path an analogue predistorted and frequency response compensated signal which is derived from the digitally predistorted and frequency response compensated signal is transmitted into a non-linear main amplifier (3);
a second signal processing path on which an analogue reference signal which is derived from the digital input signal is transmitted;
means (4, 8) for combining the amplified analogue predistorted and frequency response compensated signal and the analogue reference signal to form a fault signal and for feeding it into the second signal processing path;
means (21; 31) in the first signal processing path and means (22; 32) in the second signal processing path for varying the predistortion and frequency response compensation of the predistorted and frequency response compensated signal and the phase and the amplitude of the reference signal;
means (6) which combine the fault signal with the amplified analogue predistorted and frequency response compensated signal to form the output signal (12);
**characterized**
**in that** means (13) for logically feeding back measurement variables, which evaluate the output signal (12), to the means (21; 31) in the first signal processing path for the predistortion and frequency response compensation of the digital input signal and to the means (22; 32) in the second signal processing path for the variation of the phase and amplitude of the reference signal are provided.

10. Device according to Claim 9, **characterized in that** a second amplifier (11) in the second signal processing path is provided in order to amplify the fault signal.

11. Device according to Claim 9 or 10, **characterized in that** a unit (9) for adapting the phase and amplitude of the fault signal is provided in the second signal processing path.

12. Device according to one of Claims 9 to 11, **characterized in that** the device comprises a first delay unit (5) for delaying the analogue predistorted and frequency response compensated signal in the first signal processing path.

13. Device according to one of Claims 9 to 11, **characterized in that** a device (10) is provided for observing the fault signal in the second signal processing path.

14. Device according to one of Claims 9 to 13, **characterized in that** a second delay unit (7) for delaying the reference signal is provided in the second signal processing path upstream of the means (4, 8) for generating and providing the fault signal.

15. Device according to one of Claims 9 to 14, **characterized in that** it additionally contains:
a transmitter unit (20, 30) for generating the digital input signal;
a first signal shaping path for deriving an analogue predistorted and frequency response compensated signal from the digital predistorted and frequency response compensated signal, the output of the first signal shaping path leading into a first input line (1) which leads to the non-linear main amplifier (3) in the first signal processing path;
a second signal shaping path for deriving an analogue reference signal from the digital input signal generated by the transmitter unit; the output of the second signal shaping path leading into a second input line (2) which leads to the means (8) for generating and providing the fault signal.

16. Device according to Claim 15, **characterized in that** the first signal shaping path comprises:
a first unit (23) for digitally upmixing the signal which is output by the digital predistortion and frequency response compensation unit;
a first digital/analogue converter (27) by which the signal which is output by the first unit (23) is converted into the analogue predistorted and frequency response compensated signal;
and **in that** the second signal shaping path comprises:
a second unit (24) for digitally upmixing the signal which is output by the means (22) for varying the phase and amplitude of the reference signal;
a second digital/analogue converter (26) by which the signal which is output by the second unit (24) is converted into the analogue reference signal.

17. The device according to Claim 15, **characterized in that** the first signal shaping path comprises:
a first unit (33) for the I/Q dual digital/analogue conversion of the signal which is output by the digital predistortion and frequency response compensation unit (31);
a first I/Q modulator (35), which converts the signal, which is output by the first unit (33), into the analogue predistorted and frequency response compensated signal;
and **in that** the second signal shaping path comprises:
a second unit (34) for the I/Q dual digital/analogue conversion of the signal which is output by the means (32) for varying the phase and amplitude of the reference signal;
a second I/Q modulator (35), which converts the signal, which is output by the second unit (33), into the analogue reference signal;
the first I/Q modulator (35) and the second I/Q modulator (36) being connected via a connecting line (38) into which the signals of a local oscillator circuit unit (37) are fed.

## Revendications

1. Procédé de linéarisation d'un signal de sortie (12), en particulier d'un signal d'émission dans un émetteur qui se trouve dans une station dans un réseau radio mobile numérique,
comprenant les étapes suivantes:
prédistorsion et compensation de réponse en fréquence numériques (21; 31) d'un signal d'entrée numérique,
conversion numérique analogique (25; 33) du signal prédistordu et compensé en réponse en fréquence numériquement pour produire un signal analogique prédistordu et compensé en réponse en fréquence (1);
amplification (3) du signal analogique prédistordu et compensé en réponse en fréquence (1);
production d'un signal de référence analogique adapté en phase et en amplitude (2) à partir du signal d'entrée numérique;
production d'un signal d'erreur par soustraction l'un de l'autre du signal analogique prédistordu et compensé en réponse en fréquence qui a été amplifié et du signal de référence analogique adapté en phase et en amplitude (4, 8) et superposition (6) du signal d'erreur par le signal analogique prédistordu et compensé en réponse en fréquence qui a été amplifié, pour obtenir le signal de sortie (12),
**caractérisé en ce**
**qu'**une variation numérique (21) du signal prédistordu et compensé en réponse en fréquence numériquement ainsi qu'une adaptation de phase et d'amplitude du signal de référence sont effectuées par rétroaction logique de grandeurs mesurées évaluant le signal de sortie (12) sur le signal prédistordu et compensé en réponse en fréquence numériquement et le signal de référence adapté en phase et en amplitude.

2. Procédé selon la revendication 1,
**caractérisé par**
l'adaptation de la phase et de l'amplitude du signal d'erreur minimisé en puissance et la combinaison du signal d'erreur adapté en phase et en amplitude avec le signal analogique prédistordu et compensé en réponse en fréquence qui a été temporisé, pour obtenir un signal de sortie linéarisé.

3. Procédé selon la revendication 1 ou 2,
**caractérisé en ce**
**que** le signal analogique prédistordu et compensé en réponse en fréquence est amplifié avant la production du signal d'erreur.

4. Procédé selon l'une des revendications 1 à 3,
**caractérisé en ce**
**que** le signal d'erreur adapté en phase et en amplitude est amplifié avant la combinaison avec le signal analogique prédistordu qui a été temporisé.

5. Procédé selon l'une des revendications 1 à 4,
**caractérisé en ce**
**que** le signal analogique prédistordu et compensé en réponse en fréquence est obtenu comme suit à partir du signal prédistordu et compensé en réponse en fréquence numériquement:
up-conversion numérique optionnelle du signal prédistordu et compensé en réponse en fréquence numériquement;
conversion numérique analogique du signal prédistordu et compensé en réponse en fréquence numériquement qui a été up-converti.

6. Procédé selon l'une des revendications 1 à 4,
**caractérisé en ce**
**que** le signal analogique prédistordu et compensé en réponse en fréquence est obtenu comme suit à partir du signal prédistordu et compensé en réponse en fréquence numériquement:
conversion numérique analogique double I/Q du signal prédistordu et compensé en réponse en fréquence numériquement;
modulation I/Q du signal ayant subi une conversion numérique analogique double I/Q pour produire le signal analogique prédistordu et compensé en réponse en fréquence.

7. Procédé selon l'une des revendications 1 à 5,
**caractérisé en ce**
**que** le signal de référence est obtenu comme suit à partir du signal d'entrée numérique:
adaptation de la phase et de l'amplitude du signal d'entrée numérique;
up-conversion numérique du signal adapté en phase et en amplitude;
conversion numérique analogique du signal up-converti.

8. Procédé selon la revendication 6,
**caractérisé en ce**
**que** le signal de référence est obtenu comme suit à partir du signal d'entrée numérique:
adaptation de la phase et de l'amplitude du signal d'entrée numérique;
conversion numérique analogique double I/Q du signal adapté en phase et en amplitude;
modulation I/Q du signal ayant subi une conversion numérique analogique double I/Q pour produire le signal de référence analogique adapté en phase et en amplitude, le signal de référence modulé I/Q subissant une égalisation de fréquence avec le signal prédistordu et compensé en réponse en fréquence et modulé I/Q.

9. Dispositif de linéarisation d'un signal de sortie (12), en particulier d'un signal d'émission dans un émetteur qui est utilisable dans une station dans un réseau radio mobile numérique,
le dispositif comprenant:
un premier parcours de traitement de signaux avec une unité numérique de prédistorsion et de compensation de réponse en fréquence (21, 31), dans laquelle un signal d'entrée numérique produit dans une unité émettrice (20, 30) est injecté et subit une prédistorsion et une compensation de réponse en fréquence numériques, sur lequel un signal analogique prédistordu et compensé en réponse en fréquence qui est dérivé du signal prédistordu et compensé en réponse en fréquence numériquement est amené dans un amplificateur principal (3) non linéaire;
un deuxième parcours de traitement de signaux sur lequel est conduit un signal de référence analogique dérivé du signal d'entrée numérique;
des moyens (4, 8) pour combiner le signal analogique prédistordu et compensé en réponse en fréquence qui a été amplifié avec le signal de référence analogique pour obtenir un signal d'erreur et l'introduire dans le deuxième parcours de traitement de signaux;
des moyens (21, 31) dans le premier parcours de traitement des signaux et des moyens (22, 32) dans le deuxième parcours de traitement de signaux pour varier la prédistorsion et la compensation de réponse en fréquence du signal prédistordu et compensé en réponse en fréquence et la phase et l'amplitude du signal de référence;
des moyens (6) qui combinent le signal d'erreur avec le signal analogique prédistordu et compensé en réponse en fréquence qui a été amplifié, pour obtenir le signal de sortie (12),
**caractérisé en ce**
**que** sont prévus des moyens (13) de rétroaction logique de grandeurs mesurées évaluant le signal de sortie (12) sur les moyens (21, 31), dans le premier parcours de traitement des signaux, pour la prédistorsion et la compensation de réponse en fréquence du signal d'entrée numérique et sur les moyens (22, 32), dans le deuxième parcours de traitement des signaux, pour la variation de la phase et de l'amplitude du signal de référence.

10. Dispositif selon la revendication 9,
**caractérisé en ce**
**qu'**est prévu, dans le deuxième parcours de traitement de signaux, un deuxième amplificateur (11) pour amplifier le signal d'erreur.

11. Dispositif selon la revendication 9 ou 10,
**caractérisé en ce**
**qu'**est prévue, dans le deuxième parcours de traitement de signaux, une unité (9) d'adaptation de la phase et de l'amplitude du signal d'erreur.

12. Dispositif selon l'une des revendications 9 à 11,
**caractérisé en ce**
**que** le dispositif comprend une première unité de temporisation (5) pour temporiser le signal analogique prédistordu et compensé en réponse en fréquence dans le premier parcours de traitement de signaux.

13. Dispositif selon l'une des revendications 9 à 12,
**caractérisé en ce**
**qu'**est prévu un dispositif (10) d'observation du signal d'erreur dans le deuxième parcours de traitement de signaux.

14. Dispositif selon l'une des revendications 9 à 13,
**caractérisé en ce**
**qu'**est montée, dans le deuxième parcours de traitement de signaux, en amont des moyens (4, 8) de production et de mise à disposition du signal d'erreur, une deuxième unité de temporisation (7) pour temporiser le signal de référence.

15. Dispositif selon l'une des revendications 9 à 14,
**caractérisé en ce qu'**il contient additionnellement:
une unité émettrice (20, 30) de production du signal d'entrée numérique;
un premier parcours de mise en forme de signaux pour dériver un signal analogique prédistordu et compensé en réponse en fréquence à partir du signal numérique prédistordu et compensé en réponse en fréquence, la sortie du premier parcours de mise en forme de signaux débouchant dans une première ligne d'entrée (1) qui conduit à l'amplificateur principal (3) non linéaire dans le premier parcours de traitement de signaux;
un deuxième parcours de mise en forme de signaux pour dériver un signal de référence analogique à partir du signal d'entrée numérique produit par l'unité émettrice, la sortie du deuxième parcours de mise en forme de signaux débouchant dans une deuxième ligne d'entrée (2) qui conduit aux moyens (8) de production et de mise à disposition du signal d'erreur.

16. Dispositif selon la revendication 15,
**caractérisé en ce**
**que** le premier trajet de mise en forme de signaux comprend:
une première unité (23) d'up-conversion numérique du signal émis par l'unité numérique de prédistorsion et de compensation de réponse en fréquence;
un premier convertisseur numérique analogique (27) qui convertit le signal émis par la première unité (23) en le signal analogique prédistordu et compensé en réponse en fréquence,
et en ce que le deuxième trajet de mise en forme de signaux comprend:
une deuxième unité (24) d'up-conversion numérique du signal émis par le moyen (22) de variation de la phase et de l'amplitude du signal de référence,
un deuxième convertisseur numérique analogique (26) qui convertit le signal émis par la deuxième unité (24)en le signal de référence analogique.

17. Dispositif selon la revendication 15,
**caractérisé en ce**
**que** le premier trajet de mise en forme de signaux comprend:
une première unité (33) de conversion numérique analogique double I/Q du signal émis par l'unité numérique de prédistorsion et de compensation de réponse en fréquence (31);
un premier modulateur I/Q (35) qui convertit le signal émis par la première unité (33)en le signal analogique prédistordu et compensé en réponse en fréquence,
et en ce que le deuxième trajet de mise en forme de signaux comprend:
une deuxième unité (34) de conversion numérique analogique double I/Q du signal émis par le moyen (32) de variation de la phase et de l'amplitude du signal de référence;
un deuxième modulateur I/Q (35) qui convertit le signal émis par la deuxième unité (33)en le signal de référence analogique,
le premier modulateur I/Q (35) et le deuxième modulateur I/Q (36) étant reliés par l'intermédiaire d'une ligne de connexion (38) dans laquelle sont injectés les signaux d'une unité d'oscillateur local (37).
